# EUROPEAN PATENT APPLICATION

(11) **EP 4 765 125 A1**
(43) Date of publication of application: **24.06.2026**
(21) Application number: 24307278.2
(22) Date of filing: 23.12.2024
(51) Int. Cl.: G11C 13/04, G11C 13/06, G06N 10/40, G21K 1/00, H01S 3/04

(54) **QUANTUM MEMORY**

(71) Applicant: welinq, 75011 Paris (FR)
(72) Inventor: MAZZONI, Tommaso, 75013 Paris (FR); DARRAS, Tom, 75011 Paris (FR)
(74) Representative: Ipsilon

(57) **Abstract**

The invention relates to an assembly (11) for a quantum memory (10), the quantum memory (10) being suitable to store and retrieve a quantum information encoded into an optical signal, the assembly (11) being deprived of optical cavity and comprising:
- a vacuum chamber (12),
- a neutral atoms source (14) suitable to generate neutral atoms in the vacuum chamber (12), and
- a magneto-optical trap generator (16) suitable to generate an elongated magneto-optical trap enabling to trap neutral atoms in the vacuum chamber (12) so as to obtain an elongated ensemble of neutral atoms elongated along a so-called elongation axis, the elongation axis being along a vertical direction, the optical signal being intended to propagate in the vacuum chamber (12) along the elongation axis, the quantum information being stored in the elongated ensemble of neutral atoms or being retrieved from the elongated ensemble of neutral atoms depending on a control signal.

## Description

### TECHNICAL FIELD OF THE INVENTION

The present invention concerns an assembly for a quantum memory. The present invention also concerns an associated quantum memory.

### BACKGROUND OF THE INVENTION

In the dynamic and rapidly advancing field of quantum technologies, the development of robust and long-lived quantum memory systems constitutes a fundamental cornerstone essential for the realization of transformative applications in quantum communication, computation, and sensing. In this context, quantum memory architectures leveraging the symbiosis between cold atom ensembles and coherent reversible light-matter mapping, such as Electromagnetically Induced Transparency (EIT), have emerged as particularly promising candidates. Despite their potential, existing quantum memory implementations encounter significant constraints, notably in terms of storage duration, often constrained to temporal scales on the order of tens of microseconds.

The limitation to quantum information storage time within such systems arises from the intricate interplay between various sources of decoherence, including atomic thermal motion, magnetic field fluctuations, and the atomic cloud displacement due to gravity. These decoherence mechanisms introduce disruptive perturbations that ultimately compromise the fidelity and persistence of stored quantum states.

Another significant limitation of such systems lies in the restricted repetition time of storage trials. This constraint is primarily dictated by the preparation time required for the cold atomic ensemble and compounded by the gradual loss of efficiency. The latter arises due to the free fall of the ensemble under gravity, causing it to drift out of the interaction region with the storage photon.

Moreover, traditional quantum memory systems often grapple with intricate and delicate setups, susceptible to environmental fluctuations and challenging to maintain and deploy in on-field applications.

### SUMMARY OF THE INVENTION

Hence, there exists a need for a solution enabling an improved storage time and retrieval efficiency of a quantum information, and an improved repetition time of storage trials.

To this end, the invention relates to an assembly for a quantum memory, the quantum memory being suitable to store and retrieve a quantum information encoded into an optical signal, the assembly being deprived of optical cavity and comprising:
- a vacuum chamber,
- a neutral atoms source suitable to generate neutral atoms in the vacuum chamber, and
- a magneto-optical trap generator suitable to generate an elongated magneto-optical trap enabling to trap neutral atoms in the vacuum chamber so as to obtain an elongated ensemble of neutral atoms elongated along a so-called elongation axis, the elongation axis being along a vertical direction, the optical signal being intended to propagate in the vacuum chamber along the elongation axis, the quantum information being stored in the elongated ensemble of neutral atoms or being retrieved from the elongated ensemble of neutral atoms depending on a control signal.

The assembly according to the invention may comprise one or more of the following features considered alone or in any combination that is technically possible:
- the elongated ensemble of neutral atoms has an optical depth which is superior or equal to 200, preferably superior or equal to 400;
- the vacuum chamber comprises a top opening and a bottom opening through which the optical signal propagates in the vacuum chamber, the top opening being above the bottom opening;
- the magneto-optical trap generator comprises two pairs of anti-Helmoltz coils and a laser assembly suitable to generate three pairs of counter-propagating laser beams;
- the coils of one of the pairs of anti-Helmoltz coils have a size different from the coils of the other pair of anti-Helmoltz coils, the coils of the pairs of anti-Hemoltz coils having preferably a rectangular shape;
- the vacuum chamber comprises two pairs of transverse openings for the passage of the three pairs of counter-propagating laser beams, one of the two pairs of transverse openings being circular openings and the other pair of transverse openings being rectangular openings, the circular openings being suitable to allow the passage of one pair of counter-propagating laser beams, the rectangular openings being suitable to allow the passage of the other two pairs of counter-propagating laser beams;
- the optical aperture of each transverse opening has a size of at least 30 mm, advantageously superior or equal to 35 mm, in order to accommodate for the passage of the three pairs of counter-propagating laser beams, the three pairs of counter-propagating laser beams having advantageously a 1/e² beam width superior or equal to 35 mm;
- the vacuum chamber is made in a non-magnetic material, such as titanium;
- the neutral atoms are alkali atoms or alkali-earth atoms, the neutral atoms being preferably Rubidium atoms or Cesium atoms;
- the assembly comprises a set of coils configured to generate a magnetic field dynamically adjustable in intensity and direction within the space where the atoms are located;
- the magneto-optical trap generator comprises one additional laser source to generate a dipole trap and another laser source to compensate for the latter differential light shift;

The invention also relates to a quantum memory suitable to store and retrieve a quantum information encoded into an optical signal, the quantum memory comprising:
- an assembly as previously described, and
- a controller suitable to control the storing and retrieval of the quantum information encoded in the optical signal, the controller being suitable to dynamically send the control signal enabling the storing and the retrieval of the quantum information, so that the control signal copropagates with the optical signal in the vacuum chamber along the elongation axis.

The quantum memory according to the invention may comprise one or more of the following features considered alone or in any combination that is technically possible:
- the storing and the retrieval of the quantum information is triggered by the controller through the control signal, with one of the following protocols: electromagnetically induced transparency, a Raman protocol or a Duan-Lukin-Cirac-Zoller protocol;
- the assembly is enclosed in a magnetic shield and the quantum memory has a volume that fits in a stand-alone 19-inch rack;
- the storage and retrieval of the quantum information by the controller are spatially multiplexed so that the number of stored optical modes is at least two.

### BRIEF DESCRIPTION OF THE DRAWINGS

The invention will be easier to understand in view of the following description, provided solely as an example and with reference to the appended drawings in which:
- Figure 1 is a schematic view of an example of the principle of a quantum memory based on neutral atoms,
- Figure 2 is a schematic view of an example of elements of a quantum memory,
- Figure 3 is a schematic view of an example of a vacuum chamber of a quantum memory through which three counterpropagating laser beams of a magneto-optical trap propagate, as well as a control signal and an optical signal,
- Figure 4 is a schematic view of an example of an elongated ensemble of neutral atoms trapped at the intersection of three counterpropagating laser beams of a magneto-optical trap, a control signal and an optical signal copropagating along the elongation axis (vertical) of the elongated ensemble of neutral atoms,
- Figure 5 is a schematic view of an example of a vacuum chamber of a quantum memory and of two pairs of anti-Hemoltz coils of a magneto-optical trap,
- Figure 6 is a schematic view of an example of two pairs of anti-Hemoltz coils of a magneto-optical trap, and
- Figure 7 is an example of a plot obtained experimentally and representing the evolution of the optical depth as a function of time.

### DETAILED DESCRIPTION OF SOME EMBODIMENTS

In the description, the terms "suitable for", "able to" and "configured for" are considered equivalent.

A quantum memory is suitable to store and retrieve quantum information. The quantum information is typically a quantum state. The quantum information is for example a photonic qubit.

The quantum information is encoded (contained) into an optical signal Sₒ. The optical signal Sₒ is, for example, a single photon.

The quantum memory 10 of the invention is based on laser-cooled ensemble of neutral atoms.

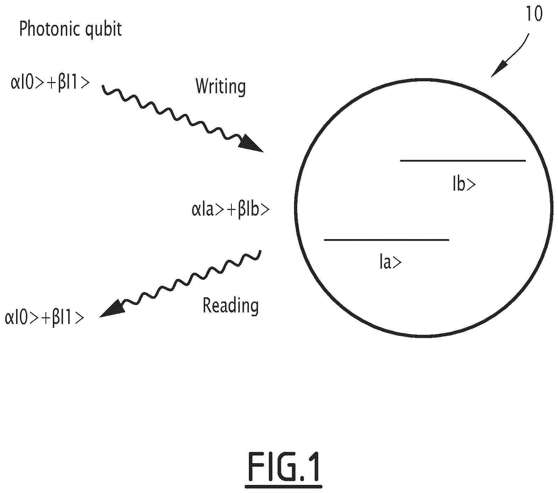

Figure 1 illustrates the principle of a quantum memory 10 based on neutral atoms. The quantum memory 10 is an on-demand quantum memory. In particular, as illustrated on figure 1, the state of a photonic qubit is converted into an atomic state. The atomic state is then read on-demand and converted back into a photonic qubit. On-demand in this context means that the retrieval of information is controlled by the user, for example by a control signal as this will be described later on.

For example, such a quantum memory 10 is suitable to be used as a repeater for long-distance communication, or for the synchronization of spatially separated quantum processors.

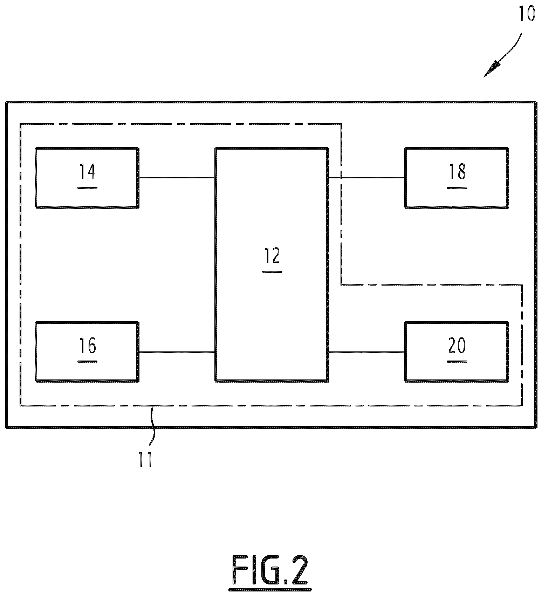

As illustrated on figure 2, the quantum memory 10 comprises an assembly 11 and a controller 18.

Preferably, the assembly 11 of the quantum memory 10 is enclosed in a magnetic shield and the quantum memory 10 (assembly 11 and controller 18) has a volume that fits in a stand-alone 19-inch rack.

The assembly 11 comprises a vacuum chamber 12, a neutral atoms source 14, and a magneto-optical trap generator 16. Optionally, the assembly 11 also comprises an optical device 20.

The vacuum chamber 12 is a chamber in which a vacuum is created during use. The vacuum is typically a ultra-high vacuum. Preferably, the pressure in the vacuum chamber 12 is lower than 1.10⁻⁹ mbar during use.

The vacuum is for example created using a pumping system.

In an example, the pumping system comprises an ion pump, a non-evaporable getter pump (NEG pump) and a valve to be connected to a turbo pump for a pre-vacuum stage.

The vacuum chamber 12 defines a geometrical frame having an horizontal axis X extending along an horizontal direction, a vertical axis Z extending along a vertical direction and a transverse axis Y which is perpendicular to the horizontal axis X and the vertical axis Z.

The vacuum chamber 12 has for example a parallelepiped shape.

Preferably, the vacuum chamber 12 is made in a non-magnetic material, for example titanium. This enables to reduce the residual magnetic fields which contribute to decoherence.

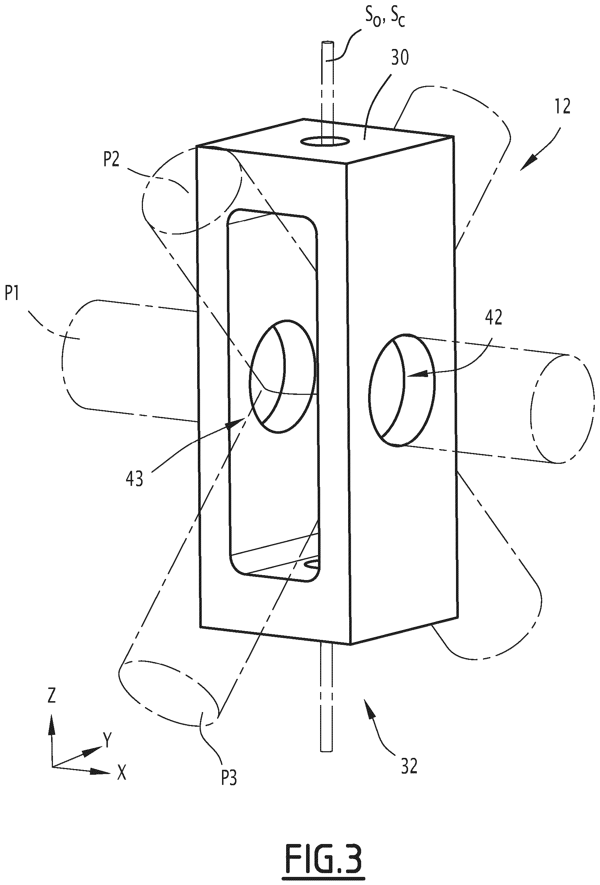

In an example of embodiment, as illustrated on figure 3, the vacuum chamber 12 comprises a top opening 30 and a bottom opening 32. The top opening 30 is above the bottom opening 32 relative to the vertical axis Z of the vacuum chamber 12.

In an example of embodiment, the top opening 30 and the bottom opening 32 are each covered by a window which is transparent at the wavelength of the optical signal Sₒ and the control signal S_{c}.

The optical signal Sₒ carrying the quantum information and the control signal S_{c} (that will be described later) are intended to propagate in the vacuum chamber 12 through the top opening 30 and the bottom opening 32.

The neutral atoms source 14 is suitable to generate neutral atoms in the vacuum chamber 12.

Preferably, the neutral atoms are alkali atoms or alkali-earth atoms. The neutral atoms are for example Rubidium atoms or Cesium atoms.

In an example of embodiment, the neutral atoms source 14 is suitable to generate a large flux of atoms, which enables after trapping the atoms, to obtain a high optical depth, which is a key parameter to obtain high memory efficiency, especially when using an EIT protocol. The optical depth or optical thickness is defined as the natural logarithm of the ratio of incident to transmitted radiant power through a material. For example, atomic ensemble of 3 cm of length can give optical depth larger than 300.

For example, the large flux and density are obtained by a combination of one or several of the following elements:
- Atomic source in proximity to the trap center.
- Large laser beams.
- Strong, asymmetric magnetic gradient.

The magneto-optical trap generator 16 is suitable to cool and trap neutral atoms in the vacuum chamber 12, enabling to obtain cold neutral atoms which are trapped in the magneto-optical trap. In particular, the magneto-optical trap generator 16 is suitable to trap neutral atoms in the vacuum chamber 12 so as to obtain an elongated ensemble of neutral atoms E elongated along a so-called elongation axis.

By the term "elongated ensemble of neutral atoms", it is understood that the atomic cloud is shaped along a preferential direction, which is along the elongation axis. Hence, the elongated ensemble of neutral atoms is shaped like a cigar with its axis corresponding to the elongation axis. Consequently, the shape of the elongated ensemble of neutral atoms is different from a sphere.

The elongation axis is along a vertical direction (direction of gravity).

The elongated magneto-optical trap is generated in free space by the magneto-optical trap generator 16.

In particular, the assembly 11 is deprived of optical cavity. Hence, the quantum memory 10 is suitable to store and retrieve a quantum information encoded into an optical signal Sₒ, in single-pass configuration. This enables avoiding the limitations due to optical cavities such as a fixed memory bandwidth or losses due to the mirrors of such optical cavities.

Preferably, the elongated ensemble of neutral atoms E has an optical depth which is superior or equal to 200, preferably superior or equal to 400. The elongated ensemble of neutral atoms E is thus a large ensemble of neutral atoms (corresponding to a large magneto-optical trap).

The optical signal Sₒ is intended to propagate in the vacuum chamber 12 along the elongation axis.

In an example of embodiment, the magneto-optical trap generator 16 comprises two pairs 40, 41 of anti-Hemoltz coils C and a laser assembly suitable to generate three pairs P1, P2, P3 of counter-propagating laser beams. Other embodiments are nonetheless possible.

By the term "counter-propagating", it is understood that the laser beams of each pair P1, P2, P3 of counter-propagating laser beams propagate in opposite direction. For example, for each pair P1, P2, P3, one of the laser beam is obtained by reflecting the other laser beam on a reflector (mirror) perpendicular to said other laser beam. In another example, each pair P1, P2, P3 comprises two laser beams which are sent in opposite direction without retro-reflection.

The elongated ensemble of neutral atoms E is generated at the intersection of the three pairs P1, P2, P3 of counter-propagating laser beams.

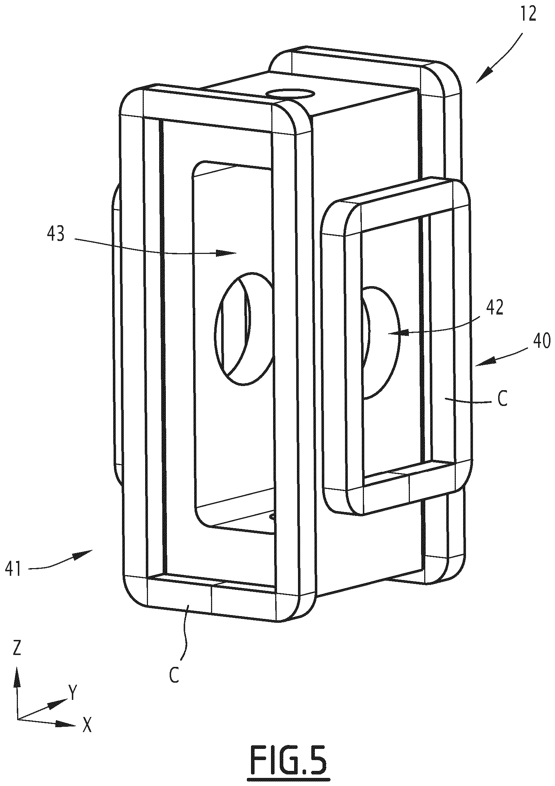

In an example of embodiment as illustrated on figures 3 and 5, the vacuum chamber 12 comprises two pairs of transverse openings 42, 43 for the passage of the three pairs P1, P2, P3 of counter-propagating laser beams.

One of the two pairs of transverse openings 42 are circular openings and the other pair of transverse openings 43 are rectangular openings. The circular openings are suitable to allow the passage of one pair P1 of counter-propagating laser beams, preferably a pair of counter-propagating laser beams propagating along a horizontal direction. The rectangular openings are suitable to allow the passage of the other two pairs P2, P3 of counter-propagating laser beams. Typically, the other two pairs of counter-propagating laser beams propagates along directions at 45° and 135° from the horizontal.

Preferably, the optical aperture of each transverse opening 42, 43 has a size of at least 30 mm, advantageously superior or equal to 35 mm, in order to accommodate for the passage of the three pairs P1, P2, P3 of counter-propagating laser beams. Advantageously, the three pairs P1, P2, P3 of counter-propagating laser beams have a 1/e² beam width superior or equal to 35 mm. The optical aperture of an optical system is defined an opening that primarily limits light propagated through the system. A 1/e² beam width is defined as being equal to the distance between the two points on the marginal distribution that are 1/e² = 0.135 times the maximum value.

In an example, the size of the vacuum chamber 12 is a compromise between:
- the MOT beams aperture, which determines the minimum width of the circular openings (for the horizontal beam).
- the 45° and 135° degree beam geometry of the other two pairs P2, P3 of counter-propagating laser beams, which determines the minimum vertical aperture of the rectangular openings.

In an example of embodiment, the transverse openings 42, 43 are each covered by a window which is transparent at the wavelength of the counter-propagating laser beams.

The coils C of each pair 40, 41 of anti-Helmoltz coils are opposite to each other (face each other).

The coils C of the pairs 40, 41 of anti-Helmoltz coils have preferably a rectangular shape.

Preferably, the two pairs 40, 41 of coils C are chosen so as to provide an asymmetric gradient on the transverse and longitudinal axis, enabling to generate the elongation for the ensemble of neutral atoms E. For example, the two pairs 40, 41 of coils C have an asymmetric aspect ratio which is chosen to provide an asymmetric gradient on the transverse and longitudinal axis of a ratio superior or equal to 10.

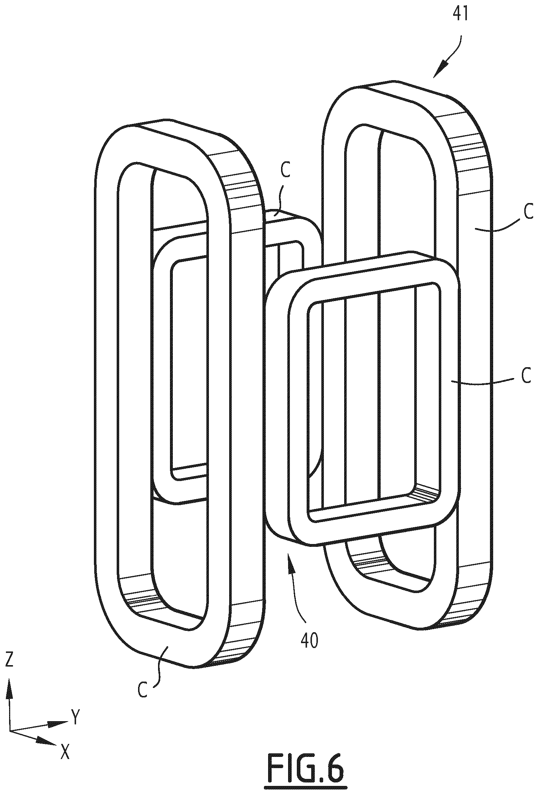

In an example of embodiment, as illustrated on figures 5 and 6, the coils C of one of the pairs 40 of anti-Helmoltz coils have a size different from the coils C of the other pair of anti-Helmoltz coils 41.

In a variant, the coils C of the two pairs 40, 41 of anti-Helmoltz coils have the same size. However, the coils C of one pair 40, 41 are positioned at different positions from a fixed point in the vacuum chamber so as to create the asymmetric gradient.

Optionally, the magneto-optical trap generator 16 comprises also one additional laser source to generate a dipole trap and another laser source to compensate for the latter differential light shift. This enables to reduce the expansion of the atoms and the fall of the atoms. Hence, this enables to increase the lifetime of the optical depth, and thus of the storage by the quantum memory 10.

The optical device 20 is suitable to carry the optical signal Sₒ to the vacuum chamber 12 and to carry an optical signal comprising the retrieved quantum information out of the vacuum chamber 12.

The controller 18 is suitable to control the storing and retrieval of the quantum information encoded in the optical signal Sₒ.

The controller 18 is suitable to dynamically send a control signal S_{c} copropagating with the optical signal Sₒ in the vacuum chamber 12 along the elongation axis.

The quantum information is stored in the elongated ensemble of neutral atoms E or is retrieved from the elongated ensemble of neutral atoms E depending on the control signal S_{c}.

In an example of embodiment, the control signal S_{c} is a laser beam, resonant with one of the atomic transitions, which creates a coherent superposition of atomic states. The optical signal Sₒ is a laser beam, resonant with a different atomic transition. Typically, the optical signal Sₒ is at the quantum level (single-photon regime) while the control signal S_{c} is a classical state with many photons.

In an example of embodiment, the storing and the retrieval of the quantum information is triggered by the controller 18 through the control signal S_{c}, by using electromagnetically induced transparency (EIT). In particular, the EIT is used dynamically.

EIT is a quantum interference phenomenon that occurs when an atomic medium interacts with precisely tuned laser fields, leading to the creation of transparency windows within the atomic absorption spectrum. This transparency effect allows a weak probe field (optical signal) to propagate through the medium without significant absorption, effectively slowing down and storing the quantum information it carries.

In a variant, other technologies are used for storing and retrieving the quantum information. For example, these other technologies used hot vapors or doped crystals.

In a variant, the storing and retrieving of the quantum information is based on a Raman protocol or a Duan-Lukin-Cirac-Zoller protocol.

Optionally, the assembly 11 comprises also a set of coils configured to generate a magnetic field dynamically adjustable in intensity and direction within the space where the atoms are located. This set of coils is different from the coils of the magneto-optical trap generator 16. This set of coils extends for example around the magneto-optical trap generator 16. This set of coils enables a fine-tune control of the electromagnetic field in the assembly 11.

The controller 18 comprises, for example, a laser source generating the control signal S_{c} and a calculator controlling the laser source (switch on or off).

Preferably, the storage and retrieval of the quantum information by the controller 18 are spatially multiplexed, so that the number of stored optical modes is at least two. In particular, the invention is compatible with the storing of at least 100 optical modes, and even more than 500 optical modes. By "spatially multiplexing", it is understood that several optical signal Sₒ are applied to the atomic ensemble, each optical signal Sₒ containing an optical mode to be stored.

An example of a method for operating the quantum memory 10 will now be described.

The method comprises a phase of preparing an elongated ensemble of neutral atoms E.

To do that the neutral atoms source 14 generates neutral atoms in the vacuum chamber 12. The magneto-optical trap generator 16 generates an elongated magneto-optical trap enabling to cool and trap the neutral atoms. In particular, atoms are cooled down to extremely low temperatures, close to absolute zero (typically on the order of 10 pK), which enables to slow down their motion and reduces their thermal energy. This cooling enables achieving long coherence times, which enables to obtain highly efficient quantum memories. No cryogenic cooling is needed.

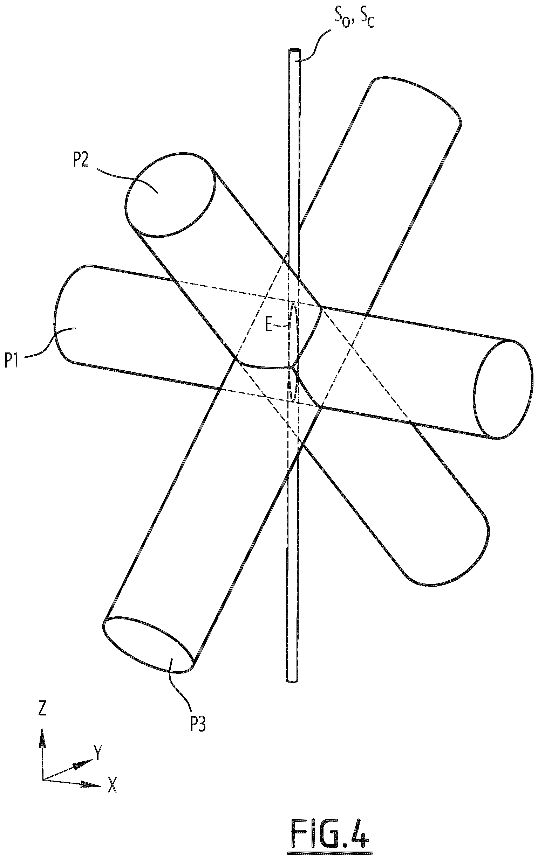

Figure 4 illustrates an elongated ensemble of neutral atoms E trapped at the intersection of three pairs P1, P2, P3 of counter-propagating laser beams. An optical signal Sₒ and a control signal S_{c} are copropagating vertically on the elongated ensemble of neutral atoms E.

The method comprises a phase of storing the quantum information in the elongated ensemble of neutral atoms E.

In an example of embodiment, quantum information is stored and retrieved using Electromagnetically Induced Transparency (EIT). In that case, when the control signal S_{c} and the optical signal Sₒ are dynamically applied to the atomic ensemble, a quantum interference effect occurs. The control signal S_{c} modifies the atomic energy levels and coherence, creating a "dark state" or a coherent superposition of atomic states. This dark state gives rise to a transparency window in the atomic absorption spectrum, where the atomic medium becomes transparent to the optical signal Sₒ.

In that example, to store a quantum state encoded in an optical signal (photon), the optical signal Sₒ containing the quantum information is sent into the atomic ensemble while the control signal S_{c} is maintained. Due to EIT, the optical signal Sₒ is significantly slowed down and temporally compressed within the atomic medium. This results in the coherent transfer of the quantum information from the optical signal Sₒ to the collective atomic excitation, effectively mapping the quantum state onto the atomic ensemble.

After the optical signal Sₒ has been slowed down, the control signal S_{c} is switched off. In this way, the collective atomic excitation is preserved and the information is stored.

The method comprises a phase of retrieving the quantum information from the elongated ensemble of neutral atoms E.

In the example of embodiment using EIT, to retrieve the stored quantum information, the control signal S_{c} is switched on. This process triggers the re-emission of the stored quantum state as a new photon, which is like the original probe field but carries the encoded information. This retrieved photon can then be detected and measured, revealing the stored quantum information.

Hence, the invention introduces an innovative quantum memory solution that capitalizes on an elongated ensemble of neutral atoms E along a vertical direction, to reduce losses and enhance storage times.

By leveraging the unique coherence properties of cold atoms, and the asymmetry of the atomic trap, this design seeks to mitigate decoherence mechanisms that can arise from the interaction of atoms with gravity. The vertical configuration provides a favorable geometry for reducing these detrimental effects, enabling prolonged storage of quantum information with heightened fidelity.

Additionally, the diminished influence of gravity significantly prolongs the duration of strong interaction between the atoms and the storage photon. This enhancement extends the optical depth lifetime up to an order of magnitude compared to a horizontal configuration. As a direct consequence, the repetition time for storage trials is improved by a similar factor, leading to a substantial increase in the success rate of entanglement generation. This advancement highlights the pivotal role of optimized geometrical configurations in improving the overall efficiency and reliability of quantum storage systems.

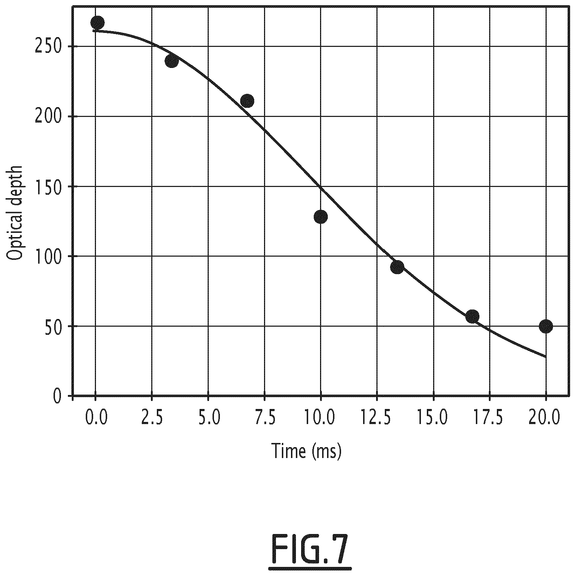

In particular, an experimentation has been performed by the inventors, enabling to obtain the plot of figure 7 representing the optical depth as a function of time. The key parameters of the experiment are the following:
- Beam power: 200 mW per beam.
- Diameter of the beam (1/e²): 45 mm.
- Coil gradients: 8 G/cm on the transverse axis.
- Atomic temperature: 50 µK.

To obtain this plot, the magnetic field was switched off at t=0 and then the optical depth was increased, relative to an horizontal configuration where atoms go out of the interaction region much faster. As shown on this figure 7, the lifetime of the optical depth is improved, here up to 13 ms, compared to the state of the art which is of the order of 4 ms.

In addition, the elongated ensemble of neutral atoms E enables to eliminate the need for an optical cavity to enhance the optical depth. The absence of cavity reduces losses and some infidelity issues.

Additionally, in the particular example of EIT, the EIT-based storage and retrieval process is highly efficient and coherent, minimizing information loss. It is also an on-demand retrieval, which is an important characteristic for efficient quantum networking applications. The ability to manipulate and control the atomic ensemble's properties enables the optimization of storage times and retrieval efficiency.

Moreover, the quantum memory of the invention can be highly compact without compromising performance, resulting in a system that is inherently robust against external perturbations. This advancement not only streamlines the integration of such a quantum memory into existing setups, but also opens avenues for on-the-field applications where stability and resilience are paramount.

Furthermore, the quantum memory of the invention can be modular, which allows for seamless customization and adaptability, catering to the specific demands of varied applications. The individual components, carefully engineered for optimal performance, can be easily assembled, and disassembled, simplifying maintenance procedures, and enabling efficient upgrades as technological advancements emerge.

The person skilled in the art will understand that the embodiments and variants described above in the description can all be combined provided that they are technically compatible. Many other embodiments are possible without departing from the scope of the invention defined in the appended claims.

## Claims

1. Assembly (11) for a quantum memory (10), the quantum memory (10) being suitable to store and retrieve a quantum information encoded into an optical signal (Sₒ), the assembly (11) being deprived of optical cavity and comprising:
- a vacuum chamber (12),
- a neutral atoms source (14) suitable to generate neutral atoms in the vacuum chamber (12), and
- a magneto-optical trap generator (16) suitable to generate an elongated magneto-optical trap enabling to trap neutral atoms in the vacuum chamber (12) so as to obtain an elongated ensemble of neutral atoms (E) elongated along a so-called elongation axis, the elongation axis being along a vertical direction, the optical signal (Sₒ) being intended to propagate in the vacuum chamber (12) along the elongation axis, the quantum information being stored in the elongated ensemble of neutral atoms (E) or being retrieved from the elongated ensemble of neutral atoms (E) depending on a control signal (S_{c}).

2. Assembly (11) according to claim 1, wherein the elongated ensemble of neutral atoms (E) has an optical depth which is superior or equal to 200, preferably superior or equal to 400.

3. Assembly (11) according to claim 1 or 2, wherein the vacuum chamber (12) comprises a top opening (30) and a bottom opening (32) through which the optical signal (Sₒ) propagates in the vacuum chamber (12), the top opening (30) being above the bottom opening (32).

4. Assembly (11) according to any one of claims 1 to 3, wherein the magneto-optical trap generator (16) comprises two pairs (40, 41) of anti-Helmoltz coils and a laser assembly suitable to generate three pairs (P1, P2, P3) of counter-propagating laser beams.

5. Assembly (11) according to claim 4, wherein the coils (C) of one of the pairs (40) of anti-Helmoltz coils have a size different from the coils (C) of the other pair (41) of anti-Helmoltz coils, the coils (C) of the pairs (40, 41) of anti-Hemoltz coils having preferably a rectangular shape.

6. Assembly (11) according to claim 4 or 5, wherein the vacuum chamber (12) comprises two pairs of transverse openings (42, 43) for the passage of the three pairs (P1, P2, P3) of counter-propagating laser beams, one of the two pairs of transverse openings (42) being circular openings and the other pair of transverse openings (43) being rectangular openings, the circular openings being suitable to allow the passage of one pair (P1) of counter-propagating laser beams, the rectangular openings being suitable to allow the passage of the other two pairs (P2, P3) of counter-propagating laser beams.

7. Assembly (11) according to claim 6, wherein the optical aperture of each transverse opening (42, 43) has a size of at least 30 mm, advantageously superior or equal to 35 mm, in order to accommodate for the passage of the three pairs (P1, P2, P3) of counter-propagating laser beams, the three pairs (P1, P2, P3) of counter-propagating laser beams having advantageously a 1/e² beam width superior or equal to 35 mm.

8. Assembly (11) according to any one of claims 1 to 7, wherein the vacuum chamber (12) is made in a non-magnetic material, such as titanium.

9. Assembly (11) according to any one of claims 1 to 8, wherein the neutral atoms are alkali atoms or alkali-earth atoms, the neutral atoms being preferably Rubidium atoms or Cesium atoms.

10. Assembly (11) according to any one of claims 1 to 9, wherein the assembly (11) comprises a set of coils configured to generate a magnetic field dynamically adjustable in intensity and direction within the space where the atoms are located.

11. Assembly (11) according to any one of claims 1 to 10, wherein the magneto-optical trap generator (16) comprises one additional laser source to generate a dipole trap and another laser source to compensate for the latter differential light shift.

12. Quantum memory (10) suitable to store and retrieve a quantum information encoded into an optical signal (Sₒ), the quantum memory (10) comprising:
- an assembly (11) according to any one of claims 1 to 11, and
- a controller (18) suitable to control the storing and retrieval of the quantum information encoded in the optical signal (Sₒ), the controller (18) being suitable to dynamically send the control signal (S_{c}) enabling the storing and the retrieval of the quantum information, so that the control signal (S_{c}) copropagates with the optical signal (Sₒ) in the vacuum chamber (12) along the elongation axis.

13. Quantum memory (10) according to claim 12, wherein the storing and the retrieval of the quantum information is triggered by the controller (18) through the control signal (S_{c}), with one of the following protocols: electromagnetically induced transparency, a Raman protocol or a Duan-Lukin-Cirac-Zoller protocol.

14. Quantum memory (10) according to claim 12 or 13, wherein the assembly (11) is enclosed in a magnetic shield and the quantum memory (10) has a volume that fits in a stand-alone 19-inch rack.

15. Quantum memory (10) according to any one of claims 1 to 14, wherein the storage and retrieval of the quantum information by the controller (18) are spatially multiplexed so that the number of stored optical modes is at least two.
